Europäisches Patentamt

European Patent Office

Office européen des brevets

(19)

(11) Veröffentlichungsnummer: **0 124 800**
**B1**

# (12) EUROPÄISCHE PATENTSCHRIFT

(45) Veröffentlichungstag der Patentschrift: **18.07.90**

(21) Anmeldenummer: **84104209.6**

(22) Anmeldetag: **13.04.84**

(51) Int. Cl.⁵: **H 05 K 1/03**

(54) Schichtpressstoff auf Epoxydharzbasis für gedruckte Schaltungen.

(30) Priorität: **05.05.83 DE 3316362**

(43) Veröffentlichungstag der Anmeldung:
**14.11.84 Patentblatt 84/46**

(45) Bekanntmachung des Hinweises auf die
Patenterteilung:
**18.07.90 Patentblatt 90/29**

(84) Benannte Vertragsstaaten:
**AT BE CH DE FR GB IT LI LU NL SE**

(56) Entgegenhaltungen:
**DE-A-1 694 281**
**US-A-3 940 534**
**US-A-3 987 230**
**US-A-4 327 143**

(73) Patentinhaber: **HÜLS TROISDORF**
**AKTIENGESELLSCHAFT**
**Postfach 11 65**
**D-5210 Troisdorf (DE)**

(72) Erfinder: **Spielau, Paul, Dr.**
**Van-Gogh-Platz 10**
**D-5210 Troisdorf-Eschmar (DE)**
Erfinder: **Fassbender, Helmut, Dr.**
**Leuchter Gemark 17**
**D-5060 Bergisch-Gladbach 2 (DE)**
Erfinder: **Weiss, Richard, Dr.**
**Stresemannstrasse 16**
**D-5210 Troisdorf (DE)**

Courier Press, Leamington Spa, England.

EP 0 124 800 B1

**Beschreibung**

Die Erfindung betrifft ein Schichtpreßstoff auf Epoxydharzbasis für gedruckte Schaltungen.

Schichtpreßstoffe für gedruckte Schaltungen werden aufgebaut aus einer Mehrzahl harzimprägnierter Bahn, glatt- oder bogenförmiger Materialien, die unter Wärme- und Druckeinwirkung zu einer Einheit verbunden und verfestigt werden. Schichtpreßstoffe, auch Laminate genannt, sind in verschiedenen Harzbindemittel-Bogenmaterial-Zusammensetzungen bekannt, um verschiedenen industriellen Forderungen hinsichtlich physikalischer elektrischer und chemischer Eigenschaften zu genügen. Schichtpreßstoffe in der modernen Elektronik für gedruckte Schaltungen sind unerläßlich und seit langem bekannt, es wird hierzu verwiesen auf den Aufsatz beispielsweise aus AEG-Mitteilungen, 49 (1959, 2/3 Seite 158 bis 160) von Rudolf Wolf "Kupferkaschierte Schichtpreßstoffe für die Elektrotechnik" und auf den Elektroanzeiger Essen, Nr. 18 vom 28. Sept. 1966, Seite 27 bis 30, Aufsatz von Kurt Borchert "Schichtpreßstoffe auf Epoxydharzbasis für gedruckte Schaltungen". Als Trägermaterialien bzw. Trägerschichten für das Epoxydharz werden überwiegend Glasgewebebahnen oder auch Papierbahnen eingesetzt. Hierbi sind die glasfaserverstärkten Epoxydharzlaminate die hochwertigsten Schichtpreßstoffe, sie werden ein- oder beidseitig mit einer Metallfolie, aus Kupfer oder Aluminium kaschiert. Hierzu wird beispielsweise auf die DE—AS 23 11 919, DE—AS 15 04 111 und DE—AS 20 20 587 und DE—OS 30 26 709 und DE—PS 24 07 923 verwiesen. Allen vorgenannten Schichtpreßstoffe auf Epoxydharzbasis ist zu eigen, daß für die mehreren Trägermaterialschichten und zwar sowohl für die inneren Schichten aus als Kernlagen bezeichnet, als auch für die äußeren Schichten als äußere Lagen bezeichnet, jeweils einheitlich das gleiche Trägermaterial entweder Glasgewebe oder Glasvlies oder Glaspapier oder Papier oder Polyestergewirk oder Asbestfasern eingesetzt wird.

Nun haben beispielsweise die Schichtpreßstoffe auf Basis von Glasfasergeweben und/oder Glasfasermatten und/oder Glasfaservliesen den Nachteil, daß sie schlecht zu bearbeiten sind, beispielsweise durch Bohren und Stanzen, was jedoch zum Herstellen der gedruckten Schaltungen notwendig ist. Man hat daher bereits versucht, die vorgenannten homogen aus einem einzigen Trägermaterial insbesondere auf Basis von Glasfasern aufgebauten Laminate durch Kombination verschiedener Trägermaterialien in unterschiedlichen Richtungen je nach Materialkombination zu verbessern, beispielsweise in Bezug auf die Bearbeitbarkeit, wie in der DE—OS 24 39 152 durch Kombination von harzimprägnierten Glawgeweben als Außenlagen und harzimprägnierten Kernlagen aus Papierbahnen. Zur Verbesserung der Eigenschaften von biegsamen Schichtpreßstoffen hat man bereits vorgeschlagen, als Trägermaterial einen gewebten Stoff aus einem Garn einzusetzen, wobei das Garn wenigstens eine Glasfaser und wenigstens eine Polyesterfaser enthält, siehe beispielsweise DE—OS 27 29 655. Zur Verbesserung der Bearbeitbarkeit ist man auch von Trägerschichten auf Basis von Glasfasern gänzlich abgegangen und hat Trägerschichten auf Basis von synthetischen Fasermaterialien in Gestalt von Vliesen, wie beispielsweise Polyestervliesen vorgeschlagen, siehe DE—AS 20 31 132. Solche Schichtpreßstoffe weisen jedoch eine geringe thermische Beständigkeit gegenüber nur mit Glasfasern verstärkten Schichtpreßstoffen auf. Gemäß DE—OS 27 26 912 ist auch der Versuch gemacht worden, Trägerplatten für gedruckte Schaltungen herzustellen, bei denen eine Kernlage aus einem kernhärtenden Kunststoffschaum ist geschlossenen Zellen und aüßere Lagen aus harzimprägnierten Papierbogen oder Glasfasergeweben vorgesehen ist.

Der vorliegenden Erfindung liegt die Aufgabe zugrunde, einer Schichtpreßstoff auf Epoxydharzbasis mit den Vorteilen der glasfaserverstärkten Epoxydharzlaminate wie die hohe Biegefestigkeit, Oberflächenwiderstand, spezifischer Durchgangswiderstand, Lichtbogenwiderstandsfähigkeit, Blasenbildungswiderstandsfähigkeit, Verbindungsfestigkeit, niedrige Wasserabsorption, niedrige Dielektrizitätskonstante, niedriger Verlustfaktor und ggf. Flammfestigkeit zu gewährleisten. Nachteilig bei all den Vorzügen ist den glasfaserverstärkten Epoxydharzlaminaten einerseits die hohen Kosten, das leichte Verwerfen bzw. Verziehen, die schlecht Bearbeitbarkeit, insbesondere schlechte Bohrbarkeit und Stanzbarkeit und Schneidbarkeit, wozu eine entsprechend hohe Werkzeugabnutzung gehört. Diese Nachteile beruhen in erster Linie auf den hohen Kosten der Glasfasergewebeverstärkung sowie der infolge des hohen prozentualen Glasgehaltes erschwerten Bearbeitbarkeit, der andererseits jedoch zur Erzielung guter physikalischer und technischer Eigenschaften erforderlich ist. Insbesondere ist es ein Anliegen der Erfindung, die Kosten für einen Schichtpreßstoff auf Epoxydharzbasis mit an glasfaserverstärkte Epoxydharzlaminate angenäherten Eigenschaften zu verringern.

Erfindungsgemäß wird diese Aufgabe durch einen neuen Schichtpreßstoff gelost, bei dem harzimprägnierte äußere Lagen enthaltend eine Trägerschicht auf Glasfaserbasis mit harzimprägnierten Kernlagen enthaltend textile Flächengebilde aus synthetischen thermoplastischen Fasern, die eine Dielektrizitätzahl $\varepsilon_T$ bei 20°C und $10^6$ Hz kleiner 5, einen dielektrischen Verlustfaktor tan $\delta$ bei 20°C und $10^6$ Hz kleiner 0,05 und eine Wasseraufnahme bei Lagerung in kaltem Wasser nach DIN 53 472 kleiner 30 mg/4 d aufweisen, miteinander verbunden sind. Überraschend hat sich herausgestellt, daß der erfindungsgemäße Schichtpreßstoff nicht nur erheblich gegenüber reinen glasfaserverstärkten Epoxydharzlaminaten preiswerter ist, sondern insbesondere verbesserte elektrische Eigenschaften und verbesserte Verarbeitbarkeit aufweist, bei nur unwesentlich verringerten mechanischen physikalischen Eigenschaftswerten. Insbesondere erweist sich bezüglich der Verbilligung des Schichtpreßstoffes das wesentlich niedrigere spezifische Gewicht der synthetischen Faservliese o.dgl. als Vorteil und darüber

2

hinaus die Tatsache, daß bei gleichen Flächengewichten synthetische Faservliese o.dgl. mehr Harz zu tragen in der Lage sind, als Glasfasergewebe o.dgl. Die überraschenden Eigenschaften des erfindungsgemäßen Schichtpreßstoffes gegenüber reinen glasfaserverstärkten Epoxyharzlaminaten sind die relativ niedrige Dielektrizitätskonstante und der dielektrische Verlustfaktor, eine leichtere und damit bessere Bearbeitbarkeit, d.h. geringerer Werkzeugverschleiß und geringere Neigung zum Ausreißen an Bohrlöchern und Stanzkanten. Gleichzeitig ist trotz des Einsatzes von synthetischen Faservliesen o.dgl. die Dimensionsstabilität des erfindungsgemäßen Schichtstoffes durch die äußeren Lagen auf Basis von Glasfasern erhalten, ebenso der Oberflächenwiderstand, die Lichtbogenwiderstandsfähigkeit, die Blasenbildungswiderstandfähigkeit, die Verbindungsfestigkeit sowie die niedrige Wasserabsorption. Damit ist es überraschend gelungen, einen Schichtpreßstoff auf Basis Epoxydharz zu schaffen, der die guten technischen Eigenschaften und verbesserte elektrische Eigenschaften gegenüber den bisher qualitativ am hochwertigsten eingeschätzten reinen glasfaserverstärkten Epoxydharzlaminaten aufweist und dennoch diesen gegenüber einen wesentlichen Preisvorteil durch den Einsatz von Kernlagen auf Basis von synthetischen Faservliesen o.dgl. aufweist.

In der eingangs zitierten Literaturstelle "Elektroanzeiger Essen" wird ausführlich auf Schichtpreßstoffe auf Epoxydharzbasis mit Trägermaterialien aus Glasgewebebahnen oder aus Papierbahnen, deren Aufbau und Eigenschaftswerten nach den verschiedenen Normen und Prüfvorschriften eingegangen. Die dielektrischen Eigenschaftswerte der Dielektrizitätszahl und des dielektrischen Verlustfaktors werden nach DIN 53 483 bestimmt, die Wasseraufnahme durch Lagerung in kaltem Wasser nach DIN 53 472.

Die für den erfindungsgemäßen Schichtpreßstoff für die Kernlagen einzusetzenden synthetischen Fasern sollen auch möglichst temperaturfest sein. Nimmt man als Maßstab die Vicaterweichungstemperatur, gemessen nach DIN 53 460, nach Verfahren B mit einer Gewichtsbelastung von 5 kp, so ist es wünschenswert, thermoplastische Kunststoffe auszuwählen, deren Vicaterweichungstemperatur möglichst über 120°C liegt. Ausnhamen bilden hier die Polyacrylnitrilfasern, deren Vicaterweichungstemperatur niedriger liegt, wobei jedoch deren Formbeständigkeit in der Wärme nach Iso/R 75 gemessen andererseits höher liegt als die der thermoplastischen linearen Polyester.

Für die textilen Flächengebilde eignen sich insbesondere Fasern aus thermoplastischen Kunststoffen, wie sie in den Ansprüchen 2 bis 6 aufgeführt sind. Hierbei können die textilen Flächengebilde sowohl nur aus einer Faser oder auch aus zwei verschidenen Fasern ausgebaut sein, darüber hinaus ist es auchmöglich, sogenannte Bikomponenten-Fasern einzusetzen. Die Auswahl des geeigneten Kunststoffes richtet sich auch nach der wirtschaftlich güngstigsten und preiswertesten Lösung, andererseits kann es jedoch zur Erzielung beispielsweise hochtemperaturefester Schichtpreßstoffe mit extremen elektrischen Eigenschaften sinnvoll sein, auch teure Kunststoffe einzusetzten. Eine bevorzugte Gruppe von Fasern sind diejenigen von linearen gesättigten Polyestern wie Polyethylenterephthalt, Polybutylenterephthalat. Eien sehr vorteilhafte Ausbildung stellen die Kombinationen aus Polyethylenterephthalt und Copolyestern von Terephthalsäure und einer zweiten Dicarbonsäure, z.B. Isophthalsäure und/oder Adipinsäure dar. Der Copolyester kann z.B. als Bikomponenten-Faser zusammen mit einem Polyethylenterephthalat bzw. als separate Bindefaser aber auch als Überzugspulver für ein Flächengebilde Pulver eingesetzt werden. Die auszuwählenden Copolyester werden in letzterem Falle dem textilen Flächengebilde in Mengen bis zu 30 Gew.-% bezogen auf das Flächengebilde zugeführt und zeichnen sich durch einen Schmelzpunkt von 190 bis 240°C aus. Die textilen Flächengebilde können als Vliese, Gewirke, Gewebe o.dgl. ausgebildet sein, wobei sie mechanisch, thermisch und/oder chemisch verfestigt sein können. Bei einer chemischen Verfestigung kommen insbesondere Binder auf Basis vonPolyacrylaten, Polyvinylacetan, Polyvinylpropionaten, Polyurethanen, Malaminharzen, Harnstofformaldehydharzen und/oder Phenolharzen in Frage. Die Vliese können als Spinnvliese hergestellt sein, als Krempelvliese auf Basis von Kurzstapelfasern, die vernadelt sind und zusätzlich thermofixiert und/oder chemisch gebunden.

Es können auch sogenannte Naßvliese eingesetztwerden, die nicht vernaldelt sind.

Je nach den gewünschten Eigenschaften wird in Weiterbildung der Erfindung vorgeschlagen, daß der Schichtpreßstoff auf der Oberseite und Unterseite je eine äußere Lage mit einer Trägerschicht auf Glasfaserbasis enthält, wobei mindestens eine Kernlage vorzugsweise mehrere Kernlagen aus textilen Flächengebilden aus synthetischen Fasern vorgesehen sind. Es ist auch möglich, bei erhöhten Anforderungen auf der Oberseite und Unterseite je zwei äußere Lagen mit einer Trägerschicht auf Glasfaserbasis vorzusehen. Die eingesetzten Trägerschichten auf Basis von Glasfasern weisen hervorzugt ein Flächengewicht von etwa 100 bis 350 g/m² auf. Die für die Trägerschichten eingesetzten Glasfasergewebe, ~matten und/oder -vliese entsprechen in der Qualität beispielsweise de nüblicherweise für die reinen glasfaserfaserverstärkten Epoxydharzlaminate für gedruckte Schaltungen eingesetzten Qualitäten. FR 4 oder CEM 3. Für die eingesetzten textilen Flächengebilde mit synthetischen Fasern kommen insbesondere Flächengewichte von etwa 100 bis 400 g/m² in Frage.

Für eine wirschaftliche Fertigung der Schichtpreßstoffe ist of ein hoher Harzanteil wünschenswert, der ebenfalls durch den erfindungsgemäß vorgeschlagenen Aufbau des Schichtpreßstoffes möglich wird. Eine vorzugsweise Ausbildung der Schichtpreßstoffe sieht vor, daß die Lagen auf Glasfaserbasis eine Epoxydharzimprägnierung mit einem Harzgehalt von etwa 40 bis 65% und die epoxydharzimprägnierten Kernlagen auf Basis von synthetische Fasern einen Harzgehalt von etwa 45 bis 85% aufweisen.

Für manche Anwendungen der Schichtpreßstoffe für gedruckte Schaltungen ist es wünschenswert, eine niedrige Dielektrizitätskonstante zu haben, wie sie glasfaserverstärkte Epoxydharzlaminate nicht

3

aufweisen. Gemäß der Erfindung ist es jedoch möglich, daß der Schichtpreßstoff eine Dielektrizitätskonstante $\varepsilon_T$ bei $10^6$ Hz und 20°C kleiner 5, insbesondere kleiner 4 aufweist. Ebenso kann der Schichtpreßstoff gemäß der Erfindung einen Verlustfaktor tan δ bei 20°C bei $10^6$ Hz kleiner 0,035 aufweisen.

Die erfindungsgemäßen Schichtpreßstoffe können einseitig oder beidseitig mit einer Metallfolie verbunden sein, insbesondere Kupferfolien oder auch Aluminiumfolien ggf. unter Verwendung eines geeigneten Haftvermittlers.

Die Schichtpreßstoffe nach der Erfindung sind lötbadfest, d.h. sie unterliegen keiner Verwerfung oder Verdrehung nach dem Aufenthalt im Lötbad und aufgrund anderer Behandlungen. die Bearbeitbarkeit ist gegenüber reinen glasfaserverstärkten Epoxydharzlaminaten verbessert. Das Bohren, Stanzen und Schneiden ist erleichtert, so daß auch die Werkzeugabnutzung verringert wird. Gegenüber reinen glasfaserverstärkten Epoxyharzlaminaten fällt der E-Modul und die Biegefestigkeit etwas ab, hält sich jedoch bei relativ hohen ausreichenden Werten.

Als Epoxydharze kommen die für die Schichtpreßstoffe in der Elektrotechnik allgemein bekannten und üblicherweise verwendeten Epoxydharze in Frage, wie sie auch im eingangs zitierten Stand der Technik beispielsweise aufgeführt sind. Das Epoxydharz kann zusätzlich übliche Zusätze wie beispielsweise chlorierte Phenyl, aromatische Phosphate, Antimontrioxyd, Titandioxyd, hydratisiertes Aluminiumoxyd usw., insbesondere zur Flammfestmachung enthalten.

Von den für die Erfindung im wesentlich einzusetzenden textilen Flächengebilde aus synthetischen Fasern sind die Polyesterfasern wegen ihrer weiten Verbreitung aus Preisweitgehend bevorzugt. Polyimidfasern und Fassern aus anderen insbesondere hochtemperaturfesten Kunstoffen wie PSU, PPO, PES, PPS hingegen sind wegen ihres hohen Preises insbesondere für Sonderanwendungen geeignet oder in Verarbeitung mit preiswerteren Polyesterfasern z.B. Bevorzugt werden textile Flächengebilde, die sich gut imprägnieren lassen und eine hohe Menge an Harz tragen, beispielsweise Gewirke oder genadelte Wirkfaservliese. Für die Imprägnierung wird das Epoxydharz niedrig viskos, insbesondere im Bereich von 15 bis 30 sec Auslauftzeit, gemessen im Fordbecher bei 4 mm Düse, beispielsweise durch Zusatz von niedrig sieden en Lösungsmitteln wie Aceton, Butanon, Spiritus o.dgl. eingestellt. An den Imprägniervorgang schließt sich eine Trocknungsprozeß an, bei dem gleichzeitig eine Vorhärtung des Imprägnierharzes stattfindet. Bei dem nachfolgenden Kaschieren der Kernlagen und äußeren Lagen unter Anwendung von Druck und Wärme entweder kontinuerlich oder diskontinuierlich in Pressen, wobei gleichzeitig ein- oder beidseitig eine Metallfolie aufkaschiert werden kann, erfolgt dann die Aushärtung des Imprägnierharzes und der einheitliche Verbund. Das Herstellverfahren des erfindungsgemäßen Schichtpreßstoffes ist analog zu den bekannten Verfahren zum Herstellen von glasfaserverstärkten Epoxydharzlaminaten. Jedoch hat es sich herausgestellt, daß eher etwas niedrigere Preßdrücke erforderlich sind im Vergleich zu reinen EPG—Laminaten. Überraschend wird das Herstellverfahren auch erleichtert, weil auch bei einer stärkeren Kondensation der einzelnen Kernlagen, d.h. bei relativ niedrigem verbliebenen Harzfluß, noch ein einwandfreies Verpressen zum Laminat ohne Delaminierung möglich ist.

Die Erfindung wird in der Zeichnung anhand von Ausführungsbeispielen erläutert.

Es zeigt die

Figur 1 schematisch in Seitenansicht die einzelnen Lagen eines Schichtpreßstoffes,

Figur 2 den fertigen Schichtpreßstoff und

Fig. 3 u. 4 zwei weitere Varianten unterschiedlich aufgebauter Schichtpreßstoffe im Querschnitt.

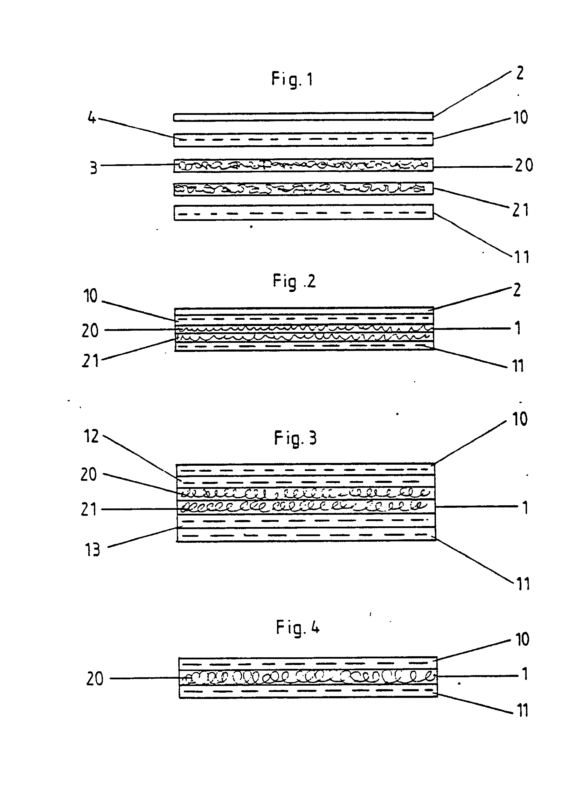

Ein erfindungsgemäßer Schichtpreßstoff wird aus mit Epoxydharz imprägnierten Lagen zusammensetzt. Gemäß Figur 1 werden die äußeren Lagen 10, 11 des Schichtpreßstoffes von mit Epoxydharz getränkten und vorimprägnierten z.B. Glasfasergeweben, -gewirken, -matten o.dgl. gebildet und die Kernlagen 20, 21 von mit dem gleichen Epoxydharz wie die äußeren Lagen imprägnierten synthetischen Faservliesen, -gewirken, -geweben o.dgl. (3).

Die Epoxydharzimprägierung für die Kernlagen kann z.B. noch mit Füllstoffen, wie Antimontrioxyd, Titandioxyd, Kaolin, Talkum und/oder Kreide angereichert werden. Dieser Schichtpreßstoffaufbau kann zusätzlich einseitig oder beidseitig mit einer Metallfolie 2, beispielsweise einer Kupferfolie verbunden werden. In der Figur 2 ist der beispielsweise in einer Etagenpresse unter Anwendung von Druck und Wärme aus den Lagen gemäß Figur 1 hergestellte Schichtpreßstoff 1 im Querschnitt gezeigt.

In der Figur 3 ist beispielhaft im Querschnitt ein weiterer Aufbau eines erfindungsgemäßen Schichtpreßstoffes 1 gezeigt, bei dem jeweils zwei äußere Lagen 10, 12 auf der Oberseite und 11, 13 auf den Unterseite aus Glasfasergewebe mit Epoxydharz imprägniert vorgesehen sind und zwei Kernlagen aus mit Epoxydharz imprägnierten Vliesen, beispielsweise Polyesterfaservliesen.

In der Figur 4 ist ein einfacher Aufbau eines Schichtpreßstoffes 1 mit je einer äußeren Lage 10, 11 aus epoxydharzimprägniertem Glasfasergewebe und einer Kernlage aus epoxydharzimprägnierten synthetischen Faservlies 20 beispielsweise einem Polyesterfaservlies oder Polyacrylnitrilfaservlies oder Polyimidfaservlies dargestellt.

Nachfolgend wird die Erfindung an einigen Beispielen erläutert.


### Beispiele 1 bis 5

Es wurden Decklagen durch Imprägnieren eines Glasfasergewebes 200 g/m² mit Epoxydharz hergestellt, wobei sich ein Glasfasergehalt zu Epoxydharzgehalt 60:40 nach Vortrocknung und Kondensation ergab. Dann wurden Kernlagen durch Imprägnieren eines Polyesterfaservlieses von 200 g/

m² aus Fasern auf Basis Polyethylenglycolterephthalat und Copolyesterfasern aus Terephthalsäure und Adipinsäure und Glykol mit dem gleichen Epoxydharz wie die Decklagen, wobei sich eine Harzgehalt von 63% nach Trocknung und Vorkondensation ergab, hergestellt.

Es wurde Epoxydharz IEC 249 von Dynamit Nobel, verdünnt 75% in Aceton-Methylglykol verwendet.

Für Beispiel 1 wurden je eine Decklage Glasfaser/Epoxyd oben und unten mit 3 Kernlagen aus Polyester/Epoxyd bei normalen Betriebsbedingungen für EPG-Laminate von etwa 160 bis 170°C während 60 min. bei etwa 60 bar abgepreßt.

Für Beispiel 2 wurden je 2 Decklagen Glasfaser/Epoxyd oben und unten mit 2 Kernlagen Polyester/Epoxyd, für Beispiel 3 je eine Decklage Glasfaser/Epoxyd oben und unten mit 2 Kernlagen Polyester/Epoxyd unter gleichen Bedingunen wie Beispiel 1 abgepreßt.

Für Vergleichbeispiel 4 wurden 5 Kernlagen Polyester/Epoxyd unter gleichen Bedingungen wie Beispiel 1 abgepreßt.

Für Vergleichbeispiel 5 wurden 8 Decklagen Glasfaser/Epoxyd unter gleichen Bedingungen wie Beispiel 1 abgepreßt, dabei ergab sich die Standardqualität eines EPG 9020 der Dynamit Nobel AG. Die außerordentlich erstaunlichen Ergebnisse der Auswertung der Eigenschaften für die erfindungsgemäßen Laminate sind der nachfolgenden Tabelle 1 zu entnehmen.

TABELLE 1

| Eigenschaft | Sollwert nach Vorschrift FR4 | Beispiele | | | Vergleiche | |
|---|---|---|---|---|---|---|
| | | 1 | 2 | 3 | 4 | 5 |
| Dicke (mm) | | 1,7 | 1,6 | 1,22 | 1,95 | 1,5 |
| Dichte (g/ml) | | 1,43 | 1,55 | 1,51 | 1,39 | 1,89 |
| Lötbadbeständigkeit (sec) bei 260°C nach DIN-IEC 52 | > 20 | >180 | >180 | >180 | 60 | >180 |
| E-Modul (N/mm$^2$) längs | 18 000 | 14 800 | 22 400 | 18 700 | 4 000 | 20 000 |
| Biegefestigkeit (N/mm$^2$) längs | 350 | 350 | 490 | 400 | 114 | 420 |
| Dielektrischer Verlustfaktor tan $\delta$ bei $10^6$ Hz·$10^{-4}$ nach Klimalagerung 96 h bei 40°C und 92 % relative Luftfeuchtigkeit DIN 53 483 | <350 | 243 | 242 | 250 | 303 | 380 |
| Dielektrischer Konstante $\varepsilon_r$ bei $10^6$ Hz nach C 96/40/92 DIN 53 483 | <5,5 | 3,9 | 4,1 | 3,8 | 3,7 | 4,5 |
| Brennbarkeit nach UL 94 (sec) | <10 | 10,3 | 7,5 | 10,1 | 12,5 | 4-7 |
| Stanzkraft Nadel 1 mm (N) | | 390 | 480 | 330 | 420 | 600 |

EP 0 124 800 B1

## Beispiele 6 bis 14

In den nachfolgenden Beispielen wurden Glasfasergewebe von 200 g/m², imprägniert mit Epoxydharz auf einen Gehalt von 40 Gew.-% Epoxydharz zu 60 Gew.-% Glas, mit verschiedenen Kunststoffaservliesen bzw. Gewebe, die ebenfalls mit Epoxydharz imprägniert wurden, in verschiedenen Schichtaufbauten laminiert, wie in Beispiel 1 beschrieben. Der Aufbau und die Eigenschaftswerte sind aus Tabelle II ersichtlich.

Es wurden folgende Vliese/Gewebe eingesetzt (Gew.-% Epoxydharz nach Trocknung und Vorkondensation):

A Polyestergewirke von 160 g/m², imprägniert auf 67 Gew.-% Epoxydharz.

B Polyacrylnitrilvlies mit Melaminharzbinder (genadeltes Wirrfaservlies), 150 g/m², imprägniert auf 85 Gew.-% Epoxydharz.

C Polyestervlies, schwer entflammbar aus TREVIRA CS® von Hoechst, ein genadeltes Wirrfaservlies von 285 g/m², imprägniert auf 75 Gew.-% Epoxydharz.

TABELLE 2

| Beispiel | Cu-Folie 35 μ | Anzahl obere Decklage EPG | Anzahl Kernlagen aus Gewebe | Anzahl untere Decklage EPG | Lötbadbeständigkeit 265°C (sec) | Brennbarkeit in sec bis zum Verlöschen |
|---|---|---|---|---|---|---|
| 6 | - | 1 | 3 A | 1 | > 120 | 4,7 |
| 7 | 1 | 1 | 4 A | 1 | > 120 | 3,4 |
| 8 | - | 2 | 2 A | 2 | > 120 | 3,4 |
| 9 | - | 2 | 1 B | 2 | 43 | 16 |
| 10 | - | 1 | 2 B | 1 | 60 | 29 |
| 11 | - | 2 | 1 C | 2 | > 120 | 2,3 |
| 12 | 1 | 2 | 1 C | 2 | 120 | 2,0 |
| 13 | 1 | 1 | 2 C | 1 | >120 | 1,9 |
| 14 | 1 | 1 | 2 C | 1 | >120 | 1,8 |

EP 0 124 800 B1

**Patentansprüche**

1. Schichtpreßstoff auf Epoxydharzbasis für gedruckte Schaltungen, dadurch gekennzeichnet, daß harzimprägnierte äußere Lagen enthaltend eine Trägerschicht auf Glasfaserbasis mit harzimprägnierten Kernlagen enthaltend textile Flächengebilde aus synthetischen thermoplastischen Fasern, die eine Dielektrizitätszahl εᴛ bei 20°C und $10^6$ Hz kleiner 5, einen dielektrischen Verlustfaktor tan δ bei 20°C und $10^6$ Hz kleiner 0,05 und ein Wasseraufnahme bei Lagerung in kaltem Wasser nach DIN 53 472 kleiner 30 mg/4 d aufweisen, miteinander verbunden sind.

2. Schichtpreßstoff nach Anspruch 1, dadurch gekennzeichnet, daß die textilen Flächengebilde Fasern von linearen gesättigten Polyestern und/oder Mischpolyestern wie Polybutylenterephthalat, Poly-1,6-cyclohexylendimethylterephthalat, Polyethylenterephthalat, Polyethylenterephthalat-Adipat und/oder Polybutylenterephthalat-Adipat enthalten.

3. Schichtpreßstoff nach Anspruch 1 oder 2, dadurch gekennzeichnet, daß die textilen Flächengebilde Fasern aus Polyamid enthalten.

4. Schichtpreßstoff nach einem der Ansprüche 1 bis 3, dadurch gekennzeichnet, daß die textilen Flächengebilde Fasern aus Polyacrylnitril und/oder Styrol-Acryl-Nitril enthalten.

5. Schichtpreßstoff nach einem der Ansprüche 1 bis 4, dadurch gekennzeichnet, daß die textilen Flächengebilde Fasern aus Polysulfon, Polyethersulfon, Polyacrylether, Polyphenylensulfid, modifiziertem Polyphenylenoxid und/oder Polyparahydroxybenzoat enthalten.

6. Schichtpreßstoff nach einem der Ansprüche 1 bis 5, dadurch gekennzeichnet, daß die textilen Flächengebilde Fasern aus Polyoxymethylen oder Polycarbonat enthalten.

7. Schichtpreßstoff nach einem der Ansprüche 1 bis 6, dadurch gekennzeichnet, daß auf der Oberseite und Unterseite je eine äußere Lage mit einer Trägerschicht aus Glasfasergewebe und/oder -vlies und/oder -matte angeordnet ist.

8. Schichtpreßstoff nach einem der Ansprüche 1 bis 6, dadurch gekennzeichnet, daß auf der Oberseite und Unterseite je zwei äußere Lagen mit einer Trägerschicht aus Glasfasergewebe und/oder -vlies und/oder -matte angeordnet sind.

9. Schichtpreßstoff nach einem der Ansprüche 1 bis 8, dadurch gekennzeichnet, daß die Trägerschicht auf Glasfaserbasis ein Flächengewicht von 100 bis 350 g/m² aufweist.

10. Schichtpreßstoff nach einem Ansprüche 1 bis 9, dadurch gekennzeichnet, daß die Trägerschichten auf Glasfaserbasis eine Epoxydharzimprägnierung mit einem Harzgehalt von etwa 40 bis 65% die epoxydharzimprägnierten Kernlagen auf Basis synthetischer Fasern einen Harzgehalt von etwa 45 bis 85% aufweisen.

11. Schichtpreßstoff nach einem der Ansprüche 1 bis 10, dadurch gekennzeichnet, daß er eine Dielektrizitätskonstante εᴛ bei $10^6$ Hz und 20°C kleiner 5, insbesondere kleiner 4,0 aufweist.

12. Schichtpreßstoff nach einem der Ansprüche 1 bis 11, dadurch gekennzeichnet, daß eine Metallfolie, insbesondere eine Kupferfolie mit mindestens einer der äußeren Lagen ggf. mittels eines Haftvermittlers verbunden ist.

13. Schichtpreßstoff nach einem der Ansprüche 1 bis 12, dadurch gekennzeichnet, daß die textilen Flächengebilde auf Basis synthetischer Fasern ein Flächengewicht von etwa 100 bis 400 g/m² aufweisen.


**Revendications**

1. Stratifié à base de résine époxy pour circuits imprimés, caractérisé en ce que des couches externes imprégnées de résine contenant une couche support à base de fibres de verre sont liées à des couches centrales imprégnées de résine contenant des structures de surface textiles en fibres thermoplastiques synthétiques, qui présentent une constante diélectrique εᴛ, à 20°C et $10^6$ Hz, inférieure à 5, un facteur de perte diélectrique tan δ, à 20°C et $10^6$ Hz, inférieur à 0,05, et une absorption d'eau, après séjour dans l'eau froide selon DIN 53 472, inférieure à 30 mg/4d.

2. Stratifié selon la revendication 1, caractérisé en ce que les structures de surface textiles contiennent des fibres de polyesters et/ou copolyesters linéaires saturés, tels que polybutylèneatéréphtalate, poly-1,6-cyclohexylénediméthyltéréphtalate, polyéthylènetéréphtalate, polyéthylènetéréphtalate-adipate et/ou polybutylènetéréphtalate-adipate.

3. Stratifié selon la revendication 1 ou 2, caractérisé en ce que les structures de surface textiles contiennent des fibres de polyimide.

4. Stratifié selon l'une des revendications 1 à 3, caractérisé en ce que les structures de surface textiles contiennent des fibres de polyacrylonitrile et/ou de poly(styrène-acrylonitrile).

5. Stratifié selon l'une des revendications 1 à 4, caractérisé en ce que les structures de surface textiles contiennent des fibres de polysulfone, polyéthersulfone, poly(éther acrylique), poly(sulfure de phénylène), poly(oxyde de phénylène) modifié et/ou poly(parahydroxybenzoate).

6. Stratifié selon l'une des revendications 1 à 5, caractérisé en ce que les structures de surface textiles contiennent des fibres en polyoxyméthylène ou polycarbonate.

7. Stratifié selon l'une des revendications 1 à 6, caractérisé en ce qu'est diposée sur la face supérieure et sur la face inférieure, à chaque fois, une couche externe avec une couche support en tissu et/ou nappe et/ou mat de fibres de verre.

9

# EP 0 124 800 B1

8. Stratifié selon l'une des revendications 1 à 6, caractérisé en ce que sont disposées sur la face supérieure et sur la face inférieure, à chaque fois, deux couches externes avec une couche support en tissu et/ou nappe et/ou mat de fibres de verre.

9. Stratifié selon l'une des revendications 1 ou 8, caractérisé en ce que la couche support à base de fibres de verre présente un poids par unité de surface de 100 à 350 g/m².

10. Stratifié selon l'une des revendications 1 ou 9, caractérisé en ce que les couches supports à base de fibres de verre présentant une imprégnation de résine époxy avec une teneur en résine d'environ 40 à 65%, et les couches centrales imprégnées de résine époxy à base de fibres synthétiques présentant une teneur en résine d'environ 45 à 85%.

11. Stratifié selon l'une des revendications 1 ou 10, caractérisé en ce qu'il présente une constante diélectrique $\varepsilon_T$, à $10^6$ Hz et 20°C, inférieure à 5, en particulier inférieure à 4,0.

12. Stratifié selon l'une des revendications 1 ou 11, caractérisé en ce qu'une feuille métallique, en particulier une feuille de cuivre, est liée à moins l'une des couches externes, éventuellement à l'aide d'un agent adhésif.

13. Stratifié selon l'une des revendications 1 à 12, caractérisé en ce que les structures de surface textiles à base de fibres synthétiques présentant un poids par unité de surface d'environ 100 à 400 g/m².

## Claims

1. Epoxy resin-based laminate for printed circuits, characterised in that resin-impregnated outer layers containing a glass fibre-based support layer with resin-impregnated core layers containing textile surface structures of synthetic thermoplastic fibres, which have a dielectric constant $\varepsilon_T$ at 20°C and $10^6$ Hz smaller than 5, a dielectric loss factor tan $\delta$ at 20°C and $10^6$ Hz smaller than 0.05 and water absorption with storage in cold water according to DIN 53 472 smaller than 30 mg/4 d, are connected with each other.

2. Laminate according to claim 1, characterised in that the textile surface structures contain fibres of linear saturated polyesters and/or copolyesters, such as polybutylene terephthalate, poly-1,6-cyclohexylene dimethylterephthalate, polyethylene terephthalate, polyethylene terephthalate-adipate and/or polybutylene terephthalate-adipate.

3. Laminate according to claim 1 or 2, characterised in that the textile surface structures contain polyimide fibres.

4. Laminate according to one of the claims 1 to 3, characterised in that the textile surface structures contain polyacrylonitrile and/or styrene-acrylonitrile fibres.

5. Laminate according to one of the claims 1 to 4, characterised in that the textile surface structures contain polysulphone, polyether sulphone, polyacrylic ether, polyphenylene sulphide, modified polyphenylene oxide and/or polyparahydroxybenzoate fibres.

6. Laminate according to one of the claims 1 to 5, characterised in that the textile surface structures contain polyoxymethylene or polycarbonate fibres.

7. Laminate according to one of the claims 1 to 6, characterised in that there is arranged on the upper side and lower side respectively an outer layer having a support layer of glass fibre woven fabric and/or glass fibre fleece and/or glass fibre non-woven fabric.

8. Laminate according to one of the claims 1 to 6, characterised in that there are arranged on the upper side and lower side respectively two outer layers having a support layer of glass fibre woven fabric and/or glass fibre fleece and/or glass fibre non-woven fabric.

9. Laminate according to one of the claims 1 to 8, characterised in that the glass fibre-based support layer has a weight per unit area of 100 to 350 g/m².

10. Laminate according to one of the claims 1 to 9, characterised in that the glass fibre-based support layers have an epoxy resin impregnation with a resin content of approximately 40 to 65%, the synthetic fibre-based, epoxy resin-impregnated core layers having a resin content of approximately 45 to 85%.

11. Laminate according to one of the claims 1 to 10, characterised in that it has a dielectric constant $\varepsilon_T$ at $10^6$ Hz and 20°C smaller than 5, more particularly smaller than 4.0.

12. Laminate according to one of the claims 1 to 11, characterised in that a metal foil, more particularly a copper foil, is connected with at least one of the outer layers, if applicable, by means of an adhesion promoter.

13. Laminate according to one of the claims 1 to 12, characterised in that the synthetic fibre-based textile surface structures have a weight per unit area of approximately 100 to 400 g/m².

10

Fig. 1

Fig .2

Fig. 3

Fig. 4